# EUROPEAN PATENT SPECIFICATION

(11) **EP 2 733 724 B1**
(45) Date of publication and mention of the grant of the patent: **24.05.2017**
(21) Application number: 12811679.5
(22) Date of filing: 22.06.2012
(51) Int. Cl.: H01L 21/304, H01L 21/027, H01L 21/28, H01L 21/336, H01L 29/78, H01L 21/02, H01L 21/311, H01L 21/67

(54) **METHOD FOR CLEANING METAL GATE SEMICONDUCTOR**
VERFAHREN ZUR REINIGUNG VON METALLGATE-HALBLEITERN
PROCÉDÉ DESTINÉ À NETTOYER UN SEMI-CONDUCTEUR À GRILLE MÉTALLIQUE

(30) Priority: 11.07.2011 JP 2011153051
(43) Date of publication of application: 21.05.2014
(73) Proprietor: Kurita Water Industries Ltd., Nakano-ku, Tokyo 164-0001 (JP)
(72) Inventor: NAGAI Tatsuo, Tokyo 164-0001 (JP); YAMAKAWA Haruyoshi, Tokyo 164-0001 (JP)
(74) Representative: Green, Mark Charles
(86) International application number: PCT/JP2012/065948
(87) International publication number: WO 2013/008605

(56) References cited:
- WO-A1-2010/113587
- JP-A- 2005 183 937
- JP-A- 2008 235 341
- JP-A- 2009 027 023
- JP-A- 2011 068 937
- US-A1- 2005 112 904
- US-A1- 2009 325 390
- US-A1- 2011 073 489
- US-A1- 2011 143 549

## Description

### TECHNICAL FIELD

The present invention as claimed in claim 1 relates to method for cleaning a semiconductor having a metal gate. Any reference to "invention" and "embodiment" is to be regarded as an example of implementation of the teachings herein unless said "invention" or "embodiment" is specifically claimed.

### BACKGROUND ART

In a semiconductor production process, processes of stripping and cleaning resist residue, fine particles, metal and natural oxide films, and the like are carried out. Regarding the cleaning liquid used in these processes, a mixed solution(SPM) of concentrated sulfuric acid and hydrogen peroxide , or a sulfuric acid solution containing ozone (SOM) in which ozone gas is dissolved in concentrated sulfuric acid is frequently used.

When hydrogen peroxide or ozone is added to a high concentration sulfuric acid , sulfuric acid is oxidized, and thus persulfuric acid (peroxomonosulfuric acid and peroxodisulfuric acid) is produced. It is known that since persulfuric acid exhibits strong oxidizing power when self-decomposed, persulfuric acid has high cleaning capability and is effective for the cleaning of substrates and the like. Meanwhile, the strong oxidizing power of persulfuric acid may be considered to be exhibited by sulfuric acid radicals that are generated as a result of the self-decomposition of the persulfuric acid.

In regard to photoresist stripping in the semiconductor production, since the employed materials used in semiconductors are generally gate electrode materials such as polysilicon, or dielectric materials such as silicon oxide, photoresist stripping is often treated mainly by the following two kinds of cleaning processes (see, for example, Patent Document 1).

One of them is a cleaning process of performing, after an ashing treatment of ashing the resist, cleaning using SPM or SOM and cleaning by SC-1 (Standard Clean 1) in sequence, and subsequently performing cleaning by SC-2 (Standard Clean 2) if necessary.

The other one is a cleaning process of performing cleaning using SPM or SOM and cleaning by SC-1 in sequence, without performing an ashing treatment, and subsequently performing cleaning by SC-2 if necessary. Meanwhile, SC-1 is a mixed solution of ammonia and aqueous hydrogen peroxide, and SC-2 is a mixed solution of hydrochloric acid and aqueous hydrogen peroxide.

The former process is generally directed to resists having dopants introduced therein in medium to large dose amounts, which are not easily stripped.

The latter process is generally directed to resists having dopants introduced therein in low dose amounts (for example, less than 5x10¹³ atoms/cm²), which can be easily stripped.

However, a semiconductor using metal gates with a linear width of 45 nm or less has been developed and put to practical use recently. In semiconductors of this kind, metal gates formed of TiN or the like are to be used as electrodes, and high dielectric constant (High-K) materials such as HfO₂-based materials are to be used as dielectrics.

Even in semiconductors that use metal gates or High-K dielectrics, the production process requires cleaning by stripping of photoresist. However, it is known that when traditional sulfuric acid-based solutions such as SPM or SOM are used for this cleaning of semiconductors, the sulfuric acid-based solutions not only strip off the resists, but also etch the metal gate materials (see, for example, Patent Documents 2 and 3).

It is desirable that the resist residue that remains after ashing be in principle eliminated by a sulfuric acid-based solution such as SPM; however, as described above, sulfuric acid-based solutions etch metal gate materials.

However, a electrolyzed sulfuric acid solution obtained by electrolyzing a sulfuric acid solution contains persulfuric acid having high oxidizing power such as described above. Thus, substrate cleaning methods of cleaning a semiconductor substrate or the like using a electrolyzed sulfuric acid solution containing such persulfuric acid as a cleaning liquid, have been proposed (see, for example, Patent Documents 4 and 5).

### CITATION LIST

Patent Document 1: Japanese Patent Application Laid-Open (JP-A) No. 61-220451
Patent Document 2: JP-A No. 8-107144
Patent Document 3: JP-A No. 2011-9452
Patent Document 4: JP-A No. 2006-114880
Patent Document 5: JP-A No. 2006-278687

US2005/112904 discloses cleaning a semiconductor having a metal gate comprising ashing a photoresist on the semiconductor; and, after the ashing step, an acid cleaning step of bringing the semiconductor that has been subjected to the ashing treatment into contact with a sulfuric acid solution containing hydrogen peroxide, thereby stripping the photoresist on the semiconductor from the semiconductor, wherein the acid cleaning solution has a liquid temperature of about 80°C.

### DISCLOSURE OF THE INVENTION

### PROBLEM TO BE SOLVED BY THE INVENTION

As described above, in the process of cleaning using SPM, SOM or the like, not only the resist is stripped off, but also the metal gate material is etched. Furthermore, even in the process of cleaning using a electrolyzed sulfuric acid solution containing persulfuric acid, the same problem of etching may occur. If further progression of microfabrication of metal gates is occurred as a result of high integration in the future, there would be a risk in which etching of metal gates caused by the cleaning liquid may greatly affect the device characteristics, production yield, and the like.

The present invention was made under such circumstances, and it is one object of the invention to provide a method for cleaning a metal gate semiconductor, by which the resist adhered to the semiconductor can be effectively stripped while etching of a metal gate is suppressed.

### MEANS FOR SOLVING PROBLEM

That is, among the methods for cleaning a metal gate semiconductor of the present invention, a first aspect of the present invention is a metal gate semiconductor cleaning method of cleaning a semiconductor having a metal gate, the method including:

A metal gate semiconductor cleaning method of cleaning a semiconductor having a metal gate, the method comprising:
an ashing step of ashing a photoresist on the semiconductor; and
after the ashing step, a persulfuric acid cleaning step of bringing the semiconductor that has been subjected to the ashing treatment into contact with a sulfuric acid solution containing persulfuric acid , and thereby stripping the photoresist on the semiconductor from the semiconductor,
wherein the sulfuric acid solution containing persulfuric acid used in the persulfuric acid cleaning step has a hydrogen peroxide concentration of 16 mM as O or less, a sulfuric acid concentration of from 90% by mass to 96% by mass, a liquid temperature of from 70°C to 130°C, and a persulfuric acid concentration of from 0.50 mM as O to 25 mM as O.

In the metal gate semiconductor cleaning method of a second aspect of the present invention, the contact time between the sulfuric acid solution containing persulfuric acid and the semiconductor in the persulfuric acid cleaning step according to the first aspect of the present invention is 5 minutes or less.

In the metal gate semiconductor cleaning method of a third aspect of the present invention, the method further includes an SC-1 cleaning step of bringing, after the persulfuric acid cleaning step according to the first or second aspect of the present invention, the semiconductor that has been cleaned in the persulfuric acid cleaning step into contact with a solution containing ammonia and hydrogen peroxide, and thereby cleaning the semiconductor.

In the metal gate semiconductor cleaning method of a fourth aspect of the present invention, the material of the metal gate according to any one of the first to third aspects of the present invention is one or more selected from TiN, NiSi and TiAlN.

In the metal gate semiconductor cleaning method of a fifth aspect of the present invention, the sulfuric acid solution containing persulfuric acid according to any one of the first to fourth aspects of the present invention is a electrolyzed sulfuric acid solution obtained by electrolyzing a sulfuric acid solution.

In the metal gate semiconductor cleaning method of a sixth aspect of the present invention, the sulfuric acid solution containing persulfuric acid according to any one of the first to fifth aspects of the present invention is a solution obtained by incorporating ozone into a sulfuric acid solution.

In the metal gate semiconductor cleaning method of a seventh aspect of the present invention, the gate width of the metal gate according to any one of the first to sixth aspects of the present invention is 45 nm or less.

In the metal gate semiconductor cleaning method of an eighth aspect of the present invention, the persulfuric acid cleaning step according to any one of the first to seventh aspects of the present invention is carried out by single wafer cleaning.

The inventors of the present application experimentally elucidated the etching behavior of a metal gate material such as TiN caused by a sulfuric acid solution containing persulfuric acid, and conducted a thorough investigation on the cleaning conditions that may be employed when a sulfuric acid solution containing persulfuric acid is used as a cleaning liquid. As a result, the inventors found the cleaning conditions under which etching of a metal gate material can be suppressed.

In regard to the etching behavior of a metal gate material such as TiN, the points listed in the following items (a) to (d) have been found.
(a) When hydrogen peroxide is present in the sulfuric acid solution, the rate of etching of the metal gate material is high.
(b) As the sulfuric acid solution has a larger content of water, the rate of etching of the metal gate material is increased.
(c) As the liquid temperature of the sulfuric acid solution is higher, the rate of etching of the metal gate material is increased.
(d) As the oxidizing agent concentration (persulfuric acid concentration) of the sulfuric acid solution is higher, the rate of etching of the metal gate material is increased. Meanwhile, examples of the metal gate material include NiSi and TiAlN and the like in addition to TiN, and it has been confirmed that these materials also exhibit the same etching behavior as that of TiN.

In the case of cleaning using SPM which is a mixed solution of concentrated sulfuric acid and hydrogen peroxide, the addition of hydrogen peroxide cannot be avoided. It may be contemplated to lower the concentration of hydrogen peroxide to a concentration at which etching of the metal gate material can be suppressed, but the concentration of Caro's acid thus generated is also decreased, and it becomes difficult to remove the resist residue after ashing. Even if etching of a metal gate material could be suppressed when SPM obtained immediately after solution preparation was used, in order to repeat the cleaning treatment, the cleaning effluent must be circulated, and thereby it is inevitable to carry out the addition of hydrogen peroxide. Accordingly, removal of the resist while suppressing etching of the metal gate material is not feasible in the process of cleaning using SPM.

Thus, according to the present invention, in order to enable suppression of etching of the metal gate material, a sulfuric acid solution containing persulfuric acid having a hydrogen peroxide concentration of 16 mM as O or less, a sulfuric acid concentration of from 90% by mass to 96% by mass, a liquid temperature of from 70°C to 130°C, and a persulfuric acid concentration of from 0.50 mM as O to 25 mM as O, is used as the sulfuric acid solution containing persulfuric acid for cleaning a semiconductor having a metal gate. Meanwhile, the unit [mM as O] used as the unit for the hydrogen peroxide concentration and the persulfuric acid concentration represents a millimolar concentration obtainable when each of the concentrations is calculated relative to the concentration of oxygen atoms generated from the respective substances.

Such a sulfuric acid solution containing persulfuric acid can be obtained by electrolyzing a sulfuric acid solution. Furthermore, the sulfuric acid solution containing persulfuric acid can also be obtained by incorporating ozone and sulfuric acid solution, and thereby generating persulfuric acid by a reaction between ozone and sulfuric acid. In addition, a sulfuric acid solution containing persulfuric acid obtained by incorporating ozone into a electrolyzed sulfuric acid solution can also be used.

However, a sulfuric acid solution containing persulfuric acid under the conditions such as described above has lower resist stripping performance as compared with SPM or the like. Thus, in the present invention, as a preceding step of the persulfuric acid cleaning step in which a sulfuric acid solution containing persulfuric acid is used as a cleaning liquid, an ashing step of performing an ashing treatment on a semiconductor having a resist adhered thereto is carried out, and thereby the resist is ashed. As such, when a persulfuric acid cleaning step using the sulfuric acid solution containing persulfuric acid described above is carried out after the ashing step, the resist adhering to the semiconductor can be reliably stripped off while etching of the metal gate material is suppressed.

Hereinafter, the processes and conditions of the present invention will be explained.

### (1) Ashing step

In the present invention, an ashing step is carried out prior to the persulfuric acid cleaning step.

In general, the ashing step is roughly classified into two processes of photoexcited ashing, by which resist stripping is carried out by irradiating light such as ultraviolet radiation and thereby using a chemical reaction between a gas and a resist; and plasma ashing, by which gas is converted to plasma by means of high frequency or the like, and the resist is stripped off utilizing the plasma. However, the method of ashing is not particularly limited in the present invention. In short, the ashing step may be any process in which a photoresist can be converted inorganic (ashed) by heating and combusting the photoresist.

Meanwhile, in the process of ashing, the extent of ashing can be regulated, but the extent of persulfuric acid cleaning can be regulated thereby within the range of conditions for the persulfuric acid cleaning step that will be described below.

### (2) Persulfuric acid cleaning step

### (a) Hydrogen peroxide concentration: 16 mM as O or less

As described above, SPM is unable to inhibit the presence of hydrogen peroxide, and the hydrogen peroxide concentration exceeds 16 mM as O. Other than SPM, for example, a sulfuric acid solution containing persulfuric acid with a very small content (16 mM as O or less) of hydrogen peroxide, which is produced by sulfuric acid electrolysis or by blowing ozone into sulfuric acid, is preferred.

### (b) Sulfuric acid concentration: From 90% by mass to 96% by mass

In order to suppress etching of the metal gate material, since a smaller water content in the sulfuric acid solution is suitable, the sulfuric acid concentration is adjusted to 90% by mass or more. Furthermore, when the sulfuric acid concentration is increased, the production efficiency of persulfuric acid in the electrolysis is deteriorated. Therefore, the sulfuric acid concentration is adjusted to 96% by mass or less. For this reason, the sulfuric acid concentration is adjusted to from 90% by mass to 96% by mass.

### (c) Persulfuric acid concentration: From 0.50 mM as O to 25 mM as O

Because persulfuric acid has a satisfactory resist stripping effect for the semiconductor after the ashing treatment and in order to prevent etching of the metal gate material, the persulfuric acid concentration is important. In order to obtain the stripping effect sufficiently, a persulfuric acid concentration of 0.50 mM as O or more is needed. On the other hand, when the sulfuric acid solution contains persulfuric acid at a concentration of greater than 25 mM as O, the rate of etching of the metal gate material is increased. Therefore, the persulfuric acid concentration is adjusted to from 0.50 mM as O to 25 mM as O. In addition, for the same reasons, it is preferable to adjust the lower limit to 5 mM as O and the upper limit to 16 mM as O. Meanwhile, when the lower limit is set to 5 mM as O, it is preferable to use a electrolyzed sulfuric acid solution as the persulfuric acid-containing sulfuric acid liquid, from the viewpoint of the persulfuric acid production efficiency.

### (d) Liquid temperature: From 70°C to 130°C

The liquid temperature of the sulfuric acid solution containing persulfuric acid is such that if the temperature is too low, the resist stripping effect is decreased, and if the temperature is too high, the oxidizing power becomes so strong that the rate of etching of the metal gate material is increased. Therefore, the temperature of the sulfuric acid solution containing persulfuric acid is set to from 70°C to 130°C.

Meanwhile, the liquid temperature is defined as the temperature required at the time of cleaning.

### (e) Contact time: 5 minutes or less

The contact time for bringing a sulfuric acid solution containing persulfuric acid have the hydrogen peroxide concentration, sulfuric acid concentration, liquid temperature and persulfuric acid concentration set as described above, into contact with the semiconductor is preferably 5 minutes or less. Since the rate of etching under the same conditions is almost constant, the amount of etching is proportional to the contact time. If the contact time is longer than 5 minutes, the amount of etching of the metal gate material becomes excessively large, and it is not preferable.

### (f) Cleaning apparatus

Furthermore, the cleaning apparatus that performs the persulfuric acid cleaning step using the sulfuric acid solution containing persulfuric acid may be a single wafer cleaning apparatus or a batch cleaning apparatus, but a single wafer cleaning apparatus is preferred. A single wafer cleaning apparatus performs washing by bringing a sulfuric acid solution containing persulfuric acid into contact with a single sheet of semiconductor each by dropwise addition, spraying or the like. By performing cleaning in a short time, the extent etching of the metal gate material can be reduced. Meanwhile, even in the case of employing a batch cleaning apparatus which performs cleaning by immersing the semiconductor in a sulfuric acid solution containing persulfuric acid , stripping of the resist can be carried out, while etching of the metal gate material is suppressed, only by cleaning in a short time.

### (3) SC-1 cleaning

In the present invention, after the persulfuric acid cleaning step described above, the semiconductor that has been cleaned in the persulfuric acid cleaning step may be subjected to an SC-1 cleaning step as desired. The SC-1 cleaning step involves cleaning of a semiconductor by bringing the semiconductor into contact with a solution containing ammonia and hydrogen peroxide (SC-1). When the SC-1 step is carried out after the persulfuric acid cleaning step, the resist residue remaining on the semiconductor can be more reliably removed.

In addition, the cleaning conditions in the SC-1 cleaning step include, for example, NH₄OH:H₂O₂:H₂O = 1:(1 to 2):5 (volume ratio), a treatment temperature of 70°C to 80°C, and a treatment time of 10 minutes to 15 minutes.

The semiconductor that serves as an object of cleaning of the present invention is not particularly limited as long as the semiconductor has a metal gate, and examples include a semiconductor wafer and a semiconductor substrate other than that, all having a metal gate formed therein.

Furthermore, the material of the metal gate is also not particularly limited in the present invention. For example, one or more selected from the group consisting of TiN, NiSi and TiAlN may be used. The present invention can be suitably applied to the cleaning of a semiconductor having a metal gate with a gate width of 45 nm or less.

### EFFECT OF THE INVENTION

As described above, according to the present invention, the metal gate semiconductor cleaning method of cleaning a semiconductor having a metal gate includes,
an ashing step of ashing the photoresist on the semiconductor; and a persulfuric acid cleaning step of bringing, after the ashing step, the semiconductor that has been subjected to the ashing step into contact with a sulfuric acid solution containing persulfuric acid , and thereby stripping the photoresist on the semiconductor from the semiconductor, and the sulfuric acid solution containing persulfuric acid used in the persulfuric acid cleaning step has a hydrogen peroxide concentration of 16 mM as O or less, a sulfuric acid concentration of from 90% by mass to 96% by mass, a liquid temperature of from 70°C to 130°C, and a persulfuric acid concentration of from 0.50 mM as O to 25 mM as O. Therefore, the resist adhering to the semiconductor can be effectively stripped off while etching of the metal gate is suppressed, and even if progression of microfabrication of metal gates were to occur as a result of high integration, the influence of etching on the metal gates would be possibly reduced.

### BRIEF DESCRIPTION OF DRAWINGS

FIG. 1 is a flow chart illustrating the each step in the semiconductor cleaning method according to an embodiment of the present invention;
FIG. 2 is a schematic diagram similarly illustrating a cleaning system for performing the persulfuric acid cleaning step;
FIG. 3 is a schematic diagram illustrating a cleaning system for performing the persulfuric acid cleaning step in the semiconductor cleaning method according to another embodiment of the present invention;
FIG. 4 is a schematic diagram illustrating a cleaning system for performing the persulfuric acid cleaning step in the semiconductor cleaning method according to still another embodiment of the present invention;
FIG. 5 is a graph illustrating the relationship between the sulfuric acid concentration of the sulfuric acid solution containing persulfuric acid and the rate of etching of a TiN film;
FIG. 6 is a graph illustrating the relationship between the liquid temperature of the sulfuric acid solution containing persulfuric acid and the rate of etching of a TiN film; and
FIG. 7 is a graph illustrating the relationship between the persulfuric acid concentration of the sulfuric acid solution containing persulfuric acid and the rate of etching of a TiN film.

### MODE FOR CARRYING OUT THE INVENTION

### (Embodiment 1)

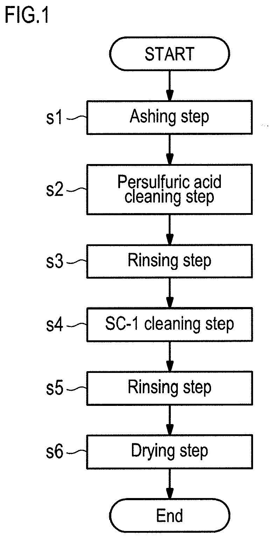

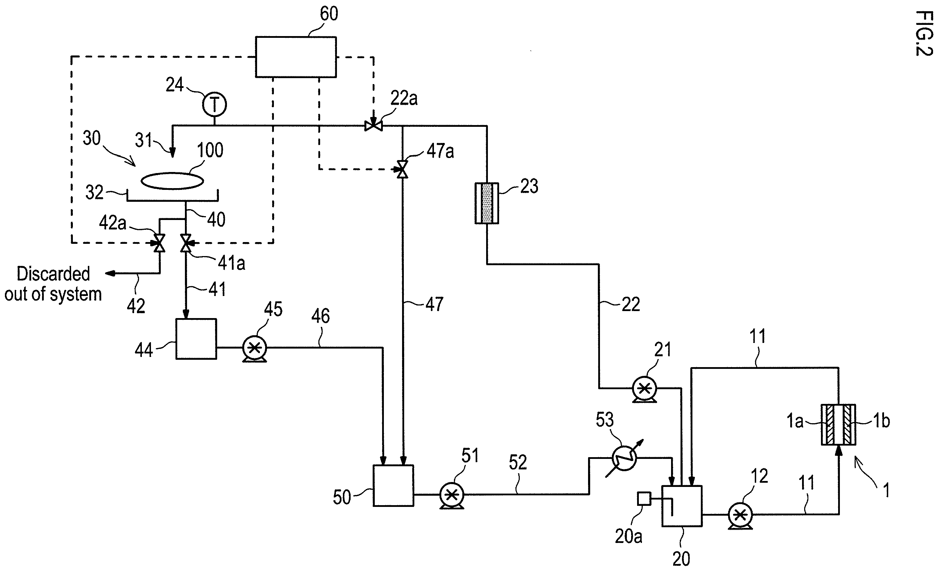

The semiconductor cleaning method according to an embodiment of the present invention will be described based on FIG. 1 and FIG. 2. FIG. 1 is a flowchart illustrating the each step in the semiconductor cleaning method according to the present embodiment. FIG. 2 is a schematic diagram illustrating a cleaning system for performing the persulfuric acid cleaning step in the semiconductor cleaning method according to the present embodiment.

The semiconductor cleaning method according to the present embodiment is directed to a semiconductor wafer having metal gates as the object to be cleaned, and strips off the resist adhering on the semiconductor wafer. The metal gates are composed of, for example, a metallic material such as TiN, NiSi or TiAlN. Furthermore, the gate width of the metal gates is, for example, 45 nm or less.

The resist to be stripped is, for example, a resist which is used as a mask at the time of patterning by photolithography of metal gates and the like; or a resist which is used as a mask at the time of injection of a dopant into a semiconductor wafer or the like.

The semiconductor cleaning method according to the present embodiment includes, as illustrated in FIG. 1, an ashing step (step s1), a persulfuric acid cleaning step (step s2), a rinsing step (step s3), an SC-1 cleaning step (step s4), a rinsing step (step s5), and a drying step (step s6). Hereinafter, the each step will be described in detail.

First, the semiconductor wafer is subjected to an ashing treatment by the ashing step, and thereby the resist is ashed (step s1). The ashing step can be carried out, for example, using a photoexcitation ashing apparatus or a plasma ashing apparatus.

The extent of ashing of the resist by the ashing step can be determined by the material of the foundation film, or the relationship with the cleaning conditions for the persulfuric acid cleaning step that is subsequently carried out. For example, regarding the extent of ashing, when the foundation film is an organic film, if the resist is subjected to full ashing, the foundation film is lost. Therefore, it is necessary to treat the resist by half-ashing or quarter-ashing. Furthermore, in the case of a highly dosed resist, half-ashing or quarter-ashing may be used in order to remove only the cured layer of the surface layer that is difficult to remove by wet cleaning. Half-ashing or quarter-ashing is generally carried out by shortening the treatment time, rather than by modifying the ashing conditions.

Subsequently, the semiconductor wafer that has been subjected to an ashing treatment in the ashing step is brought into contact with a sulfuric acid solution containing persulfuric acid by the persulfuric acid cleaning step, and thereby a semiconductor wafer is cleaned (step s2). The sulfuric acid solution containing persulfuric acid used in this step has a hydrogen peroxide concentration of 16 mM as O or less, a sulfuric acid concentration of from 90% by mass to 96% by mass, a liquid temperature of from 70°C to 130°C, and a persulfuric acid concentration of from 0.50 mM as O to 25 mM as O. The sulfuric acid solution containing persulfuric acid of the conditions described above can be obtained as a electrolyzed sulfuric acid solution by electrolyzing a sulfuric acid solution. Furthermore, a sulfuric acid solution containing persulfuric acid can also be obtained by incorporating ozone and sulfuric acid solution, and ozone can also be further added to the electrolyzed sulfuric acid solution.

When the semiconductor wafer is cleaned with a sulfuric acid solution containing persulfuric acid having the sulfuric acid concentration, liquid temperature and persulfuric acid concentration described above after the ashing step, the resist adhering to the semiconductor wafer can be reliably stripped off while etching of the metal gates is suppressed. Hereinafter, the persulfuric acid cleaning step will be described in detail.

FIG. 2 illustrates an example of a cleaning system for carrying out the persulfuric acid cleaning step. The cleaning system includes a cleaning apparatus 30 that performs the persulfuric acid cleaning step, and an electrolysis apparatus 1 that performs generation and regeneration of a sulfuric acid solution containing persulfuric acid of the conditions described above, which is formed from a electrolyzed sulfuric acid solution.

The electrolysis apparatus 1 is a diaphragmless apparatus, and an anode 1a and a cathode 1b in which at least the portion that is contact with a sulfuric acid solution are formed from diamond electrodes, are disposed inside without being separated by a diaphragm, while a direct current power supply that is not shown in the diagram is connected to the two electrodes. Meanwhile, in the present invention, the electrolysis apparatus can also be configured as an apparatus with a diaphragm, or may be an apparatus including a bipolar electrode.

The electrolysis apparatus 1 is connected with a liquid electrolyte storage tank 20 such that liquid circulation is enabled through an electrolysis side circulation line 11. Provided on the dispatch side of the electrolysis side circulation line 11 is a first circulating pump 12 that circulates a sulfuric acid solution.

The liquid electrolyte storage tank 20 is connected with a liquid delivery line 22 via a liquid delivery pump 21.

Provided on the liquid delivery side of the liquid delivery line 22 is a rapid heater 23, and the delivery terminus side of the liquid delivery line 22 is connected to a cleaning liquid nozzle 31 of the single wafer cleaning apparatus 30, via a cleaning on-off valve 22a. Meanwhile, the liquid electrolyte storage tank 20 is equipped with a persulfuric acid concentration measuring instrument 20a that measures the persulfuric acid concentration of the sulfuric acid solution in the tank.

The rapid heater 23 has a pipe channel made of quartz, and for example, the sulfuric acid solution containing persulfuric acid is rapidly heated in a once-through manner by a near-infrared heater, such that a liquid temperature of 70°C to 130°C is obtained at the outlet of the cleaning liquid nozzle 31 of the cleaning apparatus 30.

The liquid delivery line 22 is provided, on the downstream side of the position where the rapid heater 23 is provided, with a thermometer 24 that measures the liquid temperature of the sulfuric acid solution containing persulfuric acid that is delivered. The thermometer 24 is preferably disposed at a position close to the cleaning apparatus 30 so that the liquid temperature at the time of cleaning can be accurately estimated.

The single wafer cleaning apparatus 30 includes a cleaning liquid nozzle 31 that is directed toward the semiconductor wafer 100 that has been conveyed in, and a turntable (not shown in the diagram) that rotates with the semiconductor wafer 100 mounted thereon. The sulfuric acid solution containing persulfuric acid containing persulfuric acid as an oxidizing substance is sprayed or runs down in small amounts as a cleaning liquid through the cleaning liquid nozzle 31, and the sulfuric acid solution is thereby supplied to the semiconductor wafer 100 retained on the turntable. Furthermore, the cleaning apparatus 30 is connected to a common effluent line 40 for a cleaning effluent. The common effluent line 40 is diverged into a recovery line 41 and a disposal line 42, and the lines are provided with a recovery on-off valve 41a and a disposal on-off valve 42a, respectively. The liquid delivery side of the disposal line 42 is extended to the outside of the system and discharges the cleaning effluent.

The liquid delivery side end of the recovery line 41 is connected to a cleaning effluent recovery unit 44 that recovers the cleaning effluent, and the downstream side of the cleaning effluent recovery unit 44 is connected with an upstream side reflux line 46, while the upstream side reflux line 46 is provided with a first reflux pump 45.

The liquid delivery side end of the upstream side reflux line 46 is connected with a decomposition storage tank 50 that temporarily stores the sulfuric acid solution containing persulfuric acid used for cleaning, that is, the cleaning effluent. The decomposition storage tank 50 is connected with a downstream side circulation line 52, and the downstream side circulation line 52 is connected, at the liquid delivery terminus side, with the liquid electrolyte storage tank 20 via a second reflux pump 51 and a cooler 53 in sequence. Furthermore, in the liquid delivery line 22, a diverged liquid delivery line 47 is diverged on the upstream side of the cleaning on-off valve 22a, and the diverged liquid delivery line 47 is connected to a decomposition storage tank 50 via a divergence on-off valve 47a.

Both the upstream side reflux line 46 and the downstream side reflux line 52 constitute a cleaning liquid reflux line.

The operation of the cleaning on-off valve 22a, divergence on-off valve 47a, recovery on-off valve 41a, and disposal on-off valve 42a is controlled by a control unit 60. The control unit 60 is mainly composed of a CPU and a program for operating this CPU, and in addition to those, the control unit includes a RAM that serves as a working area, a ROM that stores a program and the like, a nonvolatile memory that stores control parameters, and the like.

Next, the operation of the persulfuric acid cleaning system having the configuration described above will be described.

In the liquid electrolyte storage tank 20, a sulfuric acid solution having a sulfuric acid concentration of from 90% by mass (suitably 94% by mass or more) to 96% by mass (suitably 95% by mass or less) are stored. The sulfuric acid solution is delivered by the first circulating pump 12 through the electrolysis side circulation line 11, and is introduced through the liquid feed side of the electrolysis apparatus 1. In the electrolysis apparatus 1, electricity is passed through the anode 1a and the cathode 1b by the direct current power supply, and thereby the sulfuric acid solution introduced into the electrolysis apparatus 1 is electrolyzed. Meanwhile, in the electrolysis apparatus 1, an oxidizing material containing persulfuric acid is produced on the anode side by this electrolysis.

The oxidizing material is conveyed in a state of being mixed with the sulfuric acid solution, to the liquid electrolyte storage tank 20 through the electrolysis side circulation line 11. The sulfuric acid solution contains persulfuric acid, and the persulfuric acid concentration can be increased by electrolysis by returning the sulfuric acid solution to the liquid electrolyte storage tank 20 through the electrolysis side circulation line 11, and then sending the sulfuric acid repeatedly to the electrolysis apparatus 1. Thus, a sulfuric acid solution containing persulfuric acid is generated.

The persulfuric acid concentration inside the liquid electrolyte storage tank 20 is measured with a persulfuric acid concentration measuring instrument 20a, and the electrolysis conditions for the electrolysis apparatus 1, the circulation conditions for the first circulating pump, and the like are adjusted such that the persulfuric acid concentration in the liquid electrolyte storage tank 20 reaches a predetermined concentration. Meanwhile, the configuration of the persulfuric acid concentration measuring instrument 20a is not particularly limited in the present invention, and for example, a well known configuration may be used.

Meanwhile, the measurement of the persulfuric acid concentration may be carried out to measure the concentration at a liquid delivery line 22 close to the cleaning liquid nozzle 31.

When an appropriate persulfuric acid concentration inside the liquid electrolyte storage tank 20 is obtained, a portion of the sulfuric acid solution containing persulfuric acid in the liquid electrolyte storage tank 20 is delivered by the liquid delivery pump 21 through the liquid delivery line 22. The sulfuric acid solution containing persulfuric acid flowing through the liquid delivery line 22 is rapidly heated at the rapid heater 23, and is further delivered to the cleaning apparatus 30 through the liquid delivery line 22 in which the cleaning on-off switch 22a is opened.

In the rapid heater 23, the sulfuric acid solution containing persulfuric acid is rapidly heated by a near-infrared heater while passing through a flow channel. In the rapid heater 23, the sulfuric acid solution is heated such that the liquid is delivered to the cleaning apparatus 30 and acquires a liquid temperature in the range of 70°C to 130°C at the outlet of the cleaning liquid nozzle 31. By disposing the rapid heater 23 near the cleaning apparatus 30, the heating temperature can be adjusted to be almost equal to the temperature at the time of use. The liquid delivery line 22 is provided with the thermometer 24 as described above, and the liquid temperature of the sulfuric acid solution containing persulfuric acid that has been heated by the rapid heater 23 is measured thereby. An adequate value of the liquid temperature that is measured by the thermometer 24 is defined so that a liquid temperature at the time of cleaning of from 70°C to 130°C is obtained. The heating conditions for the rapid heater 23 or the liquid delivery conditions by the liquid delivery pump 21 are adjusted so as to obtain this adequate value.

The heated sulfuric acid solution containing persulfuric acid is delivered as a cleaning liquid to the single wafer cleaning apparatus 30 through the liquid delivery line 22, and is used for the cleaning of the semiconductor wafer 100. At this time, it is desirable that the sulfuric acid solution containing persulfuric acid have the flow rate and the like adjusted such that the contact time between the solution and the semiconductor wafer 100 is 1 second or less. In the cleaning apparatus 30, the sulfuric acid solution containing persulfuric acid delivered by the liquid delivery line 22 is supplied to the semiconductor wafer 100 through the cleaning liquid nozzle 31.

The sulfuric acid solution containing persulfuric acid supplied to the semiconductor wafer 100 is subjected to the centrifugal force caused by rotation of the semiconductor wafer 100, and is spread toward the periphery over the upper surface of the semiconductor wafer 100. Thereby, the sulfuric acid solution containing persulfuric acid is widely spread over the upper surface of the semiconductor wafer 100, and thus cleaning of the semiconductor wafer 100 is achieved. The sulfuric acid solution containing persulfuric acid is splashed from the periphery and scattered laterally by the centrifugal force caused by rotation of the semiconductor wafer 100, and drops into a processing cup 32. The cleaning effluent reaching the bottom wall of the processing cup 32 is taken out to the outside of the cleaning apparatus 30 through the common effluent line 40.

The cleaning effluent collected in the cleaning effluent recovery unit 44 is delivered to the decomposition storage tank 50 by the first reflux pump 45 through the upstream reflux line 46.

The liquid retention time at the decomposition storage tank 50 is 10 minutes to 20 minutes, and is longer compared to the interval of the single wafer cleaning process. While no liquid is sent to the cleaning apparatus 30 (for example, 3 minutes - 1 minute = 2 minutes), the cleaning on-off valve 22a is closed, and the divergence on-off valve 47a is opened, so that the liquid coming from the rapid heater 23 is directly received in the decomposition storage tank 50 through the divergent liquid delivery line 47, and by using this as an oxidizing agent, an undecomposed resist can be oxidized and decomposed. The cleaning effluent having a decreased resist concentration is returned to the liquid electrolyte storage tank 20 by the second reflux pump 51 through the downstream side reflux line 52. At this time, the cleaning effluent is cooled by a cooler 53 to a temperature appropriate for electrolysis, for example, 40°C to 90°C. The cleaning effluent returned to the liquid electrolyte storage tank 20 is subjected to electrolysis again in the electrolysis apparatus 1 while being circulated through the electrolysis side circulation line 11 to increase the persulfuric acid concentration, and the cleaning effluent is regenerated as a cleaning liquid. This is circulated and used for cleaning.

After the persulfuric acid cleaning step and a rinsing cleaning step, in the SC-1 cleaning step, the semiconductor wafer is brought into contact with a solution containing ammonia and hydrogen peroxide, and thus the semiconductor wafer is cleaned (step s4). The cleaning conditions for the SC-1 cleaning step include, for example, NH₄OH:H₂O₂:H₂O = 1:(1 to 2):5 (volume ratio), a treatment temperature of 70°C to 80°C, and a treatment time of 10 minutes to 15 minutes.

Next, the semiconductor wafer that has been cleaned in the SC-1 cleaning step is rinsed with pure water or the like by a rinsing step (step s5), and subsequently, the semiconductor wafer that has been rinsed in the rinsing step is dried by a drying step (step s6).

### (Embodiment 2)

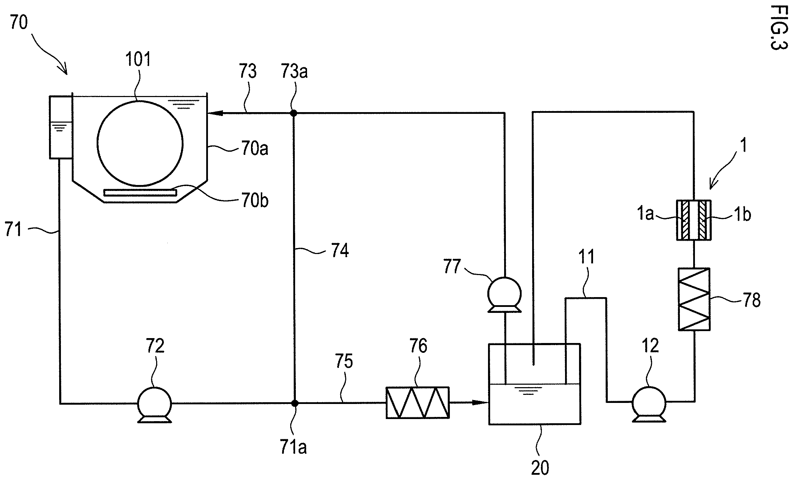

Next, the semiconductor cleaning method according to another embodiment of the present invention will be described by way of FIG. 3. FIG. 3 is a schematic diagram illustrating a cleaning system for performing the persulfuric acid cleaning step in the semiconductor cleaning method according to the present embodiment. Meanwhile, for the same configuration as that of the embodiment 1, the same symbols will be assigned so that any further description will not be repeated or will be made brief.

In the embodiment 1, the case of using a single wafer cleaning apparatus 30 as the cleaning apparatus performing the persulfuric acid cleaning step was described, but a batch cleaning apparatus may also be used. The semiconductor cleaning method according to the present embodiment is to use a batch cleaning apparatus 70 instead of the single wafer cleaning apparatus 30 as the cleaning apparatus for performing the persulfuric acid cleaning step.

As illustrated in FIG. 3, the batch cleaning apparatus 70 includes a cleaning tank 70a filled with a sulfuric acid solution containing persulfuric acid, and a heater 70b provided on the bottom of the cleaning tank 70a.

The liquid dispatch side of the cleaning tank 70a is connected with a common effluent line 71. The common effluent line 71 is provided with a pump 72. Furthermore, the liquid reception side of the cleaning tank 70a is connected with a common supply line 73. The common effluent line 71 is diverged into two lines at the downstream end, and the common supply line 73 is formed by two lines converging at the upstream end. Thus, the divergence point 71a of the common effluent line 71 and the convergence point 73a of the common supply line 73 are connected by a connection line for use side circulation 74.

The use side circulation line is composed of the common effluent line 71, the connection line for use side circulation 74, and the common supply line 73.

Furthermore, the divergence point 71a of the common effluent line 71 and the convergence point 73a of the common supply line 73 are connected with a connection line for use side storage part circulation 75 through a liquid electrolyte storage tank 20, and circulation of the sulfuric acid solution containing persulfuric acid is enabled between the cleaning apparatus 70 and the liquid electrolyte storage tank 20. The circulation line for use side storage part is composed of the common effluent line 71, the connection line for use side storage part circulation 75, and the common supply line 73.

As described above, the common effluent line 71 and the common supply line 73 are shared by the use side circulation line and the use side storage part circulation line.

The outward route side of the connection line for use side storage part circulation 75 is provided with a cooler 76 and is connected to the liquid electrolyte storage tank 20 at the downstream end.

Furthermore, the return route side of the connection line for use side storage part circulation 75 is provided with a pump 77 and is connected to the convergence point 73a at the downstream end.

Furthermore, another liquid dispatch side and another liquid reception side of the liquid electrolyte storage tank 20 are connected with an electrolysis side circulation line 11 through the electrolysis apparatus 1, and circulation of a sulfuric acid solution is enabled between the liquid electrolyte storage tank 20 and the electrolysis apparatus 1. The outward route side of the electrolysis side circulation line 11 is provided with a first circulating pump 12.

Next, the operation of the persulfuric acid cleaning system illustrated in FIG. 3 will be described.

The cleaning tank 70a is filled with a sulfuric acid solution, and the sulfuric acid solution is circulated through the use side circulation line, the use side storage part circulation line, and the electrolysis side circulation line 11. At this time, electricity is passed between an anode 1a and a cathode 1b in the electrolysis apparatus 1, and the sulfuric acid solution that is passed through the electrolysis apparatus 1 is electrolyzed. Thus, a electrolyzed sulfuric acid solution is obtained. The cleaning tank 70a is filled with the electrolyzed sulfuric acid solution that has acquired a predetermined persulfuric acid concentration as a result of circulation of the sulfuric acid solution, and the electrolyzed sulfuric acid solution is heated to 70°C to 130°C by a heater 70b.

In this manner, plural sheets of semiconductor wafers 101 are immersed in the sulfuric acid solution containing persulfuric acid of the predetermined conditions filled in the cleaning tank 70a, and the persulfuric acid cleaning step is carried out.

The sulfuric acid solution in the cleaning tank 70a is discharged through the common effluent line 71 by a pump 72, along with the circulation described above. The sulfuric acid solution discharged through the common effluent line 71 reaches the divergence point 71a. Meanwhile, a filter may be provided in the common effluent line 71, and solid components such as resist in the sulfuric acid solution may be captured and removed from the sulfuric acid solution by means of the filter.

At the divergence point 71a, a portion of the sulfuric acid solution flows into the connection line for use side circulation 74, and the remaining portion flows into the outward route of the connection line for use side storage part circulation 75.

The sulfuric acid solution of an appropriate amount that has flowed into the outward route of the connection line for use side storage part circulation 75 at the divergence point 71a is forcibly cooled by a cooler 76, and is introduced into the liquid reception side of the liquid electrolyte storage tank 20. At the cooler 76, the sulfuric acid solution is forcibly cooled to, for example, 10°C to 80°C.

Furthermore, in the liquid electrolyte storage tank 20, the sulfuric acid solution is discharged through the electrolysis side circulation line 11 by a first circulation pump 12, and the sulfuric acid solution is forcibly cooled by a cooler 78 to a temperature suitable for electrolysis in the electrolysis apparatus 1, for example, 30°C to 70°C.

In the electrolysis apparatus 1, the sulfuric acid solution is electrolyzed as the liquid is passed between the anode 1a and the cathode 1b through which electricity is passed by a power supply device, and thus persulfuric acid is generated in the sulfuric acid solution. The sulfuric acid solution containing persulfuric acid is discharged through the effluent side of the electrolysis apparatus 1, and is returned to the liquid electrolyte storage tank 20 through the return route of the electrolysis side circulation line 11. As this operation is repeated, the persulfuric acid concentration in the electrolyzed sulfuric acid solution in the liquid electrolyte storage tank 20 is increased.

The electrolyzed sulfuric acid solution in the liquid electrolyte storage tank 20 is taken out through the return route of the connection line for use side storage part circulation 75 by a pump 77, and is delivered to the convergence point 73a. Meanwhile, a filter may be provided in the return route of the connection line for use side storage part circulation 75, and solids such as fine particles in the electrolyzed sulfuric acid solution or sulfur precipitates produced by electrolysis may be captured and removed from the electrolyzed sulfuric acid solution.

The electrolyzed sulfuric acid solution delivered to the convergence point 73a through the return route of the connection line for use side storage part circulation 75 is combined with the sulfuric acid solution delivered through the connection line for use side circulation 74 at the convergence point 73a, and then is introduced into the cleaning tank 70a through the common supply line 73 to be used again for cleaning.

As such, the persulfuric acid cleaning step may be carried out using a batch cleaning apparatus 70 that performs cleaning by immersing plurality of semiconductor wafers 101 in a sulfuric acid solution containing persulfuric acid , instead of the single wafer cleaning apparatus 30. Even in the case of using the batch cleaning apparatus 70, the contact time between the semiconductor wafers 101 and the sulfuric acid solution containing persulfuric acid is preferably adjusted to 5 minutes or less, as described above.

### (Embodiment 3)

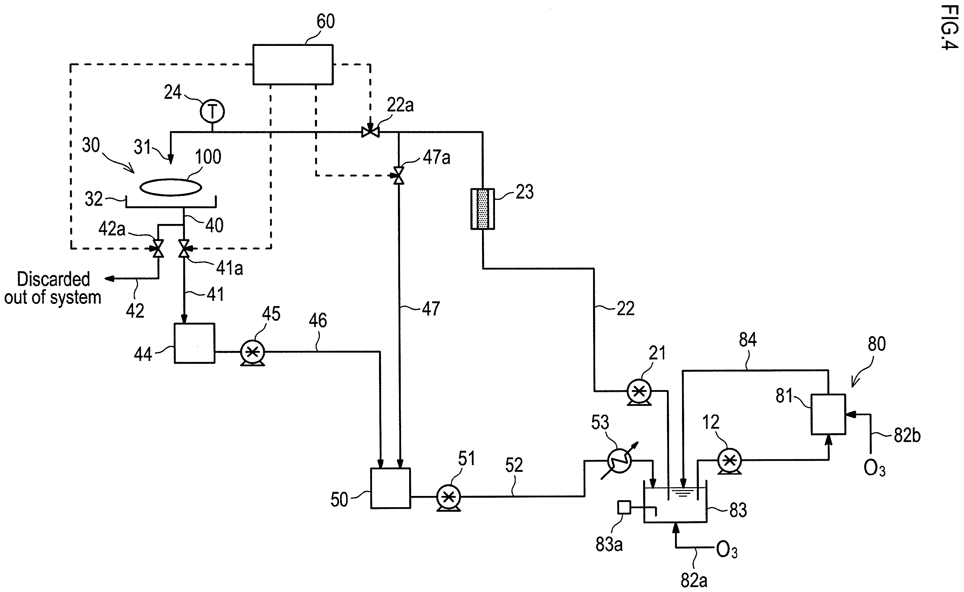

Next, the semiconductor cleaning method according to still another embodiment of the present embodiment will be described by way of FIG. 4. FIG. 4 is a schematic diagram illustrating the cleaning system for performing the persulfuric acid cleaning step in the semiconductor cleaning method according to the present embodiment. Meanwhile, for the same configuration as that of the embodiments 1 and 2, the same symbols will be assigned so that any further description will not be repeated or will be made brief.

In the embodiment 1, the case of using a electrolyzed sulfuric acid solution obtained by electrolyzing a sulfuric acid solution as the sulfuric acid solution containing persulfuric acid was described; however, the sulfuric acid solution containing persulfuric acid may be a solution obtained by other methods. The semiconductor cleaning method according to the present embodiment uses, as the sulfuric acid solution containing persulfuric acid , a product obtained by incorporating ozone and sulfuric acid solution and generating persulfuric acid by a reaction between sulfuric acid and ozone. Therefore, the semiconductor cleaning method according to the present embodiment uses a generating apparatus for sulfuric acid solution containing persulfuric acid 80 that generates a sulfuric acid solution containing persulfuric acid by incorporating ozone into a sulfuric acid solution, instead of the electrolysis apparatus 1.

As illustrated in FIG. 4, a storage tank 83 is provided instead of the liquid electrolyte storage tank 20. The storage tank 83 is connected with a liquid delivery line 22 and a downstream side circulation line 52 as described above.

Furthermore, the storage tank 83 is provided with a persulfuric acid concentration measuring instrument 83a that measures the persulfuric acid concentration in the storage tank 83, similarly to the each embodiment described above. Also, the storage tank 83 is provided with an ozone blowing unit 82a that blows ozone gas into the sulfuric acid solution in the storage tank 83.

The generating apparatus for sulfuric acid solution containing persulfuric acid 80 includes an ozone dissolution unit 81 that dissolves ozone in a sulfuric acid solution with a sulfuric acid concentration of from 90% by mass to 96% by mass; and an ozone blowing unit 82b that blows ozone gas into the sulfuric acid solution in the ozone dissolution unit 81. The ozone dissolution unit 81 is connected to the storage tank 83 through a circulation line 84 so as to enable liquid passage and circulation. The dispatch side of the circulation line 84 is provided with a first circulating pump 12 that circulates the sulfuric acid solution.

In the generating apparatus for sulfuric acid solution containing persulfuric acid 80, a sulfuric acid solution containing persulfuric acid is generated as follows. The sulfuric acid solution stored in the storage tank 83 is delivered to the ozone dissolution unit 81 through the circulation line 84 by the first circulating pump 12, and ozone gas is blown by the ozone blowing unit 82b. Thereby, ozone is dissolved in the sulfuric acid solution, and persulfuric acid is generated by a reaction between sulfuric acid and ozone. The sulfuric acid solution containing persulfuric acid in the ozone dissolution unit 81 is returned to the storage tank 83 through the circulation line 84, and then the concentration of persulfuric acid can be increased by repeating the operation of sending the sulfuric acid solution to the generating apparatus for sulfuric acid solution containing persulfuric acid 80 and blowing ozone gas therein. In this manner, a sulfuric acid solution containing persulfuric acid is generated.

The persulfuric acid concentration in the storage tank 83 is measured with a persulfuric acid concentration measuring instrument 83a. When an appropriate persulfuric acid concentration is obtained, a portion of the sulfuric acid solution containing persulfuric acid in the storage tank 83 is delivered through a liquid delivery line 22 by a liquid delivery pump 21, and is used as a cleaning liquid in the cleaning apparatus 30. At this time, the temperature of the sulfuric acid solution containing persulfuric acid is measured with a thermometer 24 so that an appropriate temperature may be obtained at the time of cleaning.

Meanwhile, in the sulfuric acid solution containing persulfuric acid in the storage tank 83, ozone gas is blown continuously or intermittently by the ozone blowing unit 82a, and ozone is dissolved in the sulfuric acid solution. Thereby, the persulfuric acid concentration of the sulfuric acid solution containing persulfuric acid in the storage tank 83 can be maintained constant.

The cleaning effluent generated in the cleaning apparatus 30 is recovered in the cleaning effluent recovery unit 44 through the recovery line 41, or is discharged to the outside of the system through a disposal line 42, as in the case of the embodiment 1. The cleaning effluent collected in the cleaning effluent recovery unit 44 is delivered to a decomposition storage tank 50 in the same manner as in the embodiment 1, and achieves oxidation and decomposition of undecomposed resist. Thereafter, the cleaning effluent is returned to the storage tank 83 through a downstream side reflux line 52 by a second reflux pump 51. The cleaning effluent returned to the storage tank 83 has the persulfuric acid concentration therein increased by performing blowing of ozone gas again in the generating apparatus for sulfuric acid solution containing persulfuric acid 80 while circulating through a circulation line 84, and is thus regenerated as a cleaning liquid. This regenerated cleaning liquid is circulated and used for cleaning.

### EXAMPLES

### (Experimental Example 1)

The following experiment was carried out so that the relationship between the sulfuric acid concentration of the sulfuric acid solution containing persulfuric acid and the rate of etching of the metal gate material can be determined.

In this experiment, a TiN film, which is one kind of metal gate material, was formed on a semiconductor wafer, and this was used as a test material. This test material was treated by immersing in electrolyzed sulfuric acid solutions having different sulfuric acid concentrations, and the rates of etching of the TiN film were measured. Meanwhile, the liquid temperature of the electrolyzed sulfuric acid solution was set to 130°C, the persulfuric acid concentration was set to 15 mM as O to 21 mM as O, and the treatment time was set to 5 minutes. The hydrogen peroxide concentration of this electrolyzed sulfuric acid solution was 16 mM as O or less.

Furthermore, regarding the rate of etching, a change in the TiN film was determined with a spectroscopic ellipsometer, and the reduced film thickness was divided by 5 minutes of the treatment time to determine the rate of etching.

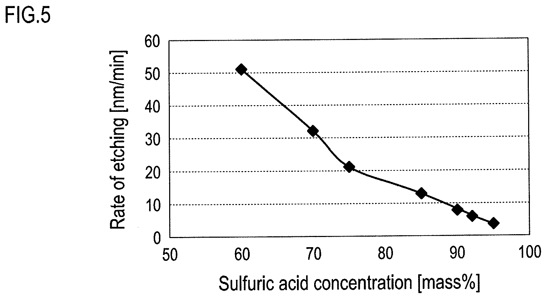

The results of the experiment described above are presented in Table 1 and FIG. 5.

As can be clearly seen from the experimental results shown in Table 1 and FIG. 5, it is understood that when the sulfuric acid concentration of the electrolyzed sulfuric acid solution is 90% by mass or more, the rate of etching of the TiN film is 10 nm/min or less, and when the sulfuric acid concentration is 94% by mass or more, the rate of etching is 5 nm/min or less.

Thus, in the present invention, the sulfuric acid concentration of the persulfuric acid-containing sulfuric acid is set to be 90% by mass or more. In addition, if the sulfuric acid concentration is excessively high, the production efficiency of persulfuric acid by electrolysis is deteriorated. Therefore, the sulfuric acid concentration is set to be 96% by mass or less.

**[Table 1]**

| **Sulfuric acid concentration [mass%]** | **Rate of etching [nm/min]** |
|---|---|
| **60** | **51** |
| **70** | **32** |
| **75** | **21** |
| **85** | **10** |
| **90** | **7** |
| **92** | **6** |
| **96** | **4** |

### (Experimental Example 2)

Next, the relationship between the liquid temperature of the sulfuric acid solution containing persulfuric acid and the rate of etching of the metal gate material was experimentally determined. In this experiment, a test material such as described above was treated by immersing in electrolyzed sulfuric acid solutions having different liquid temperatures, and the rates of etching of the TiN film were measured. Meanwhile, the sulfuric acid concentration of the electrolyzed sulfuric acid solution was set to 92% by mass, the persulfuric acid concentration was set to 15 mM as O to 21 mM as O, and the treatment time was set to 5 minutes. Furthermore, the rate of etching was determined in the same manner as described above. The hydrogen peroxide concentration of this electrolyzed sulfuric acid solution was 16 mM as O or less.

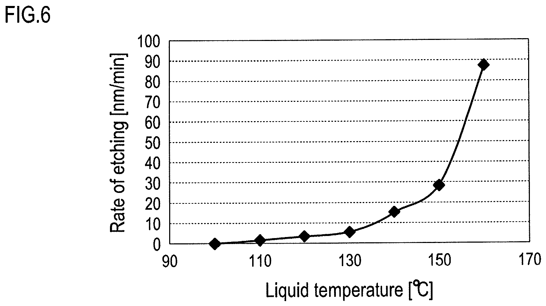

The results of the experiment described above are presented in Table 2 and FIG. 6.

As can be clearly seen from the experimental results shown in Table 2 and FIG. 6, it is understood that when the liquid temperature of the electrolyzed sulfuric acid solution is 130°C or lower, the rate of etching of the TiN film is 10 nm/min or less, and when the liquid temperature is 125°C or lower, the rate of etching is 5 nm/min or less.

Thus, in the present invention, the liquid temperature of the sulfuric acid solution containing persulfuric acid is set to 130°C or lower. In addition, if the liquid temperature is too low, the resist stripping performance becomes unsatisfactory; therefore, the liquid temperature is set to be 70°C or higher.

**[Table 2]**

| **Liquid temperature [°C]** | **Rate of etching [nm/min]** |
|---|---|
| **100** | **0.0** |
| **110** | **1.2** |
| **120** | **3.0** |
| **130** | **5.3** |
| **140** | **15.3** |
| **150** | **28.7** |
| **160** | **88.0** |

### (Experimental Example 3)

Next, the relationship between the persulfuric acid concentration of the sulfuric acid solution containing persulfuric acid and the rate of etching of the metal gate material was experimentally determined. In this experiment, a test material such as described above was treated by immersing in electrolyzed sulfuric acid solutions having different persulfuric acid concentrations, and the rates of etching of the TiN film were measured. Meanwhile, the sulfuric acid concentration of the electrolyzed sulfuric acid solution was set to 92% by mass, the liquid temperature was set to 130°C, and the treatment time was set to 5 minutes. Furthermore, the rate of etching was determined in the same manner as described above. The hydrogen peroxide concentration of this electrolyzed sulfuric acid solution was 16 mM as O or less.

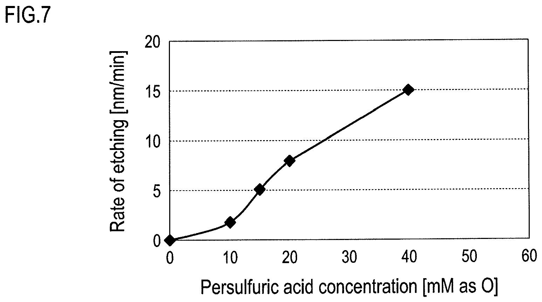

The results of the experiment described above are presented in Table 3 and FIG. 7.

As can be clearly seen from the experimental results shown in Table 3 and FIG. 7, it is understood that when the persulfuric acid concentration is 25 mM as O or less, the rate of etching of the TiN film is 10 nm/min or less, and when the persulfuric acid concentration is 16 mM as O or less, the rate of etching is 5 nm/min or less.

Thus, in the present invention, the persulfuric acid concentration of the sulfuric acid solution containing persulfuric acid is set to 25 mM as O or less. In addition, if the persulfuric acid concentration is too low, the resist stripping performance becomes unsatisfactory; therefore, the persulfuric acid concentration is set to be 0.50 mM as O or greater.

**[Table 3]**

| **Persulfuric acid concentration [mM as O]** | **Rate of etching [nm/min]** |
|---|---|
| **0** | **0** |
| **10** | **2** |
| **16** | **5** |
| **21** | **8** |
| **42** | **15** |

A wafer in which metal gates were formed from a TiN film and then the resist was ashed by performing an ashing treatment, was prepared as a test material that is to be subjected to a cleaning treatment. The wafer thus prepared was subjected to a cleaning treatment under predetermined treatment conditions, and the extent of remaining of the resist residue on the wafer, and the presence or absence of the loss of the TiN film by etching were observed. Meanwhile, in the washing treatment, a persulfuric acid cleaning step of using a electrolyzed sulfuric acid solution (hydrogen peroxide concentration: 5 mM as O to 16 mM as O) as the sulfuric acid solution containing persulfuric acid, or an SC-1 cleaning step were carried out, or the both steps were carried out sequentially. The treatment conditions and treatment results for the cleaning treatment of Examples 1 to 8 and Comparative Examples 1 to 5 are presented in the following Table 4.

**[Table 4]**

| | Treatment conditions | | | | Treatment results | | Evaluation |
|---|---|---|---|---|---|---|---|
| | Sulfuric acid solution containing persulfuric acid | | | SC-1 | Resist residue | Film loss | |
| | Treatment temperature | Sulfuric acid concentration | Persulfuric acid concentration | | | | |
| <Liquid temperature was varied> | | | | | | | |
| Comparative Example 1 | 60° C | 90% | 25mM as O | Present | Little | Infinitesimal | × |
| Example 1 | 70° C | 90% | 25mM as O | Present | Infinitesimal | Infinitesimal | ⊚ |
| Example 2 | 130° C | 90% | 25mM as O | Present | Infinitesimal | Very little | ○ |
| Comparative Example 2 | 140° C | 90% | 25mM as O | Present | Infinitesimal | Medium | × |
| <Sulfuric acid concentration was varied> | | | | | | | |
| Comparative Example 3 | 100° C | 85% | 16mM as O | Present | Infinitesimal | Little | × |
| Example 3 | 100° C | 90% | 16mM as O | Present | Infinitesimal | Very little | ○ |
| Example 4 | 100° C | 92% | 16mM as O | Present | Infinitesimal | Very little | ○ |
| <Persulfuric acid concentration was varied> | | | | | | | |
| Comparative Example 4 | 130° C | 96% | 0.47mM as O | Present | Little | Infinitesimal | × |
| Example 5 | 130° C | 96% | 0.52mM as O | Present | Very little | Infinitesimal | ○ |
| Example 6 | 130° C | 96% | 5.2mM as O | Present | Infinitesimal | Infinitesimal | ⊚ |
| Example 7 | 130° C | 96% | 25mM as O | Present | Infinitesimal | Very little | ○ |
| Comparative Example 5 | 130° C | 96% | 42mM as O | Present | Infinitesimal | Little | × |
| <Presence or absence of SC-1> | | | | | | | |
| Example 8 | 100° C | 92% | 16mM as O | Absent | Very little | Very little | Δ |
| Example 4 | 100° C | 92% | 16mM as O | Present | Infinitesimal | Very little | ○ |

As shown in the above Table 4, it was found that a liquid temperature of 70°C to 130°C, a sulfuric acid concentration of 90% by mass or more, and a persulfuric acid concentration of 0.52 mM as O to 25 mM as O are preferred from the viewpoints of the removal of the resist residue and the film loss.

Regarding the resist residue, by using visual inspection, an optical microscope or a laser microscope, it was rated as "Infinitesimal" when the resist residue was not recognized by even by an epi-illumination method; it was rated as "Very little" when the resist residue was not recognized by the naked eye, but was observed by the epi-illumination method; it was rated as "Little" when the resist residue was recognized by the naked eye; and it was rated as "Medium" when a significant amount of the resist residue was recognized by the naked eye. Furthermore, the film loss was measured using a spectroscopic ellipsometer, and a sample with an amount of etching of less than 1.0 nm was rated as "Infinitesimal"; a sample with an amount of etching of more than or equal to 1.0 nm and less than 2.5 nm was rated as "Very little"; a sample with an amount of etching of more than or equal to 2.5 nm and less than 5.0 nm was rated as "Little"; and a sample with an amount of etching of 5.0 nm or more was rated as "Medium".

In the comprehensive evaluation, a sample rated as "Infinitesimal" for both the resist residue and the film loss was assigned with the symbol ⊚; a sample rated as "Infinitesimal" for one of the resist residue and the film loss and "Very little" for the other was assigned with the symbol ○; a sample rated as "Very little" for both the resist residue and the film loss was assigned with the symbol Δ; and a sample with other combinations was assigned with the symbol ×.

The treatment conditions and treatment results for the cleaning treatments of Examples 9 to 16 and Comparative Examples 6 to 9 that were carried out by using a solution (hydrogen peroxide concentration: 5 mM as O to 16 mM as O) obtained by dissolving ozone in a sulfuric acid solution as the sulfuric acid solution containing persulfuric acid s of Examples 1 to 8 and Comparative Examples 1 to 5, are as shown in the following Table 5.

Regarding the ratings of the resist residue and film loss, and the comprehensive evaluation, the same format as the results of the above Table 4 was used.

**[Table 5]**

| | Treatment conditions | | | | Treatment results | | Evaluation |
|---|---|---|---|---|---|---|---|
| | Sulfuric acid solution containing persulfuric acid | | | SC-1 | Resist residue | Film loss | |
| | Treatment temperature | Sulfuric acid concentration | Persulfuric acid concentration | | | | |
| <Liquid temperature was varied> | | | | | | | |
| Comparative Example 6 | 60° C | 90% | 2.6mM as O | Present | Medium | Infinitesimal | × |
| Example 9 | 70° C | 90% | 2.6mM as O | Present | Very little | Infinitesimal | ○ |
| Example 10 | 130° C | 90% | 2.6mM as O | Present | Infinitesimal | Very little | ○ |
| Comparative Example 7 | 140° C | 90% | 2.6mM as O | Present | Infinitesimal | Medium | × |
| <Sulfuric acid concentration was varied> | | | | | | | |
| Comparative Example 8 | 100° C | 85% | 5.2mM as O | Present | Very little | Little | × |
| Example 11 | 100° C | 90% | 5.2mM as O | Present | Infinitesimal | Very little | ○ |
| Example 12 | 100° C | 92% | 5.2mM as O | Present | Infinitesimal | Very little | ○ |
| <Persulfuric acid concentration was varied> | | | | | | | |
| Comparative Example 9 | 130° C | 96% | 0.47mM as O | Present | Little | Infinitesimal | × |
| Example 13 | 130° C | 96% | 0.52mM as O | Present | Very little | Infinitesimal | ○ |
| Example 14 | 130° C | 96% | 16mM as O | Present | Infinitesimal | Infinitesimal | ⊚ |
| Example 15 | 130° C | 96% | 25mM as O | Present | Infinitesimal | Very little | ○ |
| <Presence or absence of SC-1> | | | | | | | |
| Example 16 | 100° C | 92% | 5.2mM as O | Absent | Very little | Very little | Δ |
| Example 12 | 100° C | 92% | 5.2mM as O | Present | Infinitesimal | Very little | ○ |

### EXPLANATIONS OF LETTERS OR NUMERALS

1 electrolysis apparatus
11 electrolysis side circulation line
20 liquid electrolyte storage tank
22 liquid delivery line
23 rapid heater
30 cleaning apparatus
31 cleaning liquid nozzle
40 common effluent line
41 recovery line
41a recovery on-off valve
42 disposal line
42a disposal on-off valve
46 upstream side circulation line
49 measuring unit
50 decomposition storage tank
52 downstream side circulation line
60 control unit
70 cleaning apparatus
80 generating apparatus for sulfuric acid solution containing persulfuric acid

## Claims

1. A metal gate semiconductor cleaning method of cleaning a semiconductor having a metal gate, the method comprising:
an ashing step of ashing a photoresist on the semiconductor; and
after the ashing step, a persulfuric acid cleaning step of bringing the semiconductor that has been subjected to the ashing treatment into contact with a sulfuric acid solution containing persulfuric acid, and thereby stripping the photoresist on the semiconductor from the semiconductor,
wherein the sulfuric acid solution containing persulfuric acid used in the persulfuric acid cleaning step has a hydrogen peroxide concentration of 16 mM as O or less, a sulfuric acid concentration of from 90% by mass to 96% by mass, a liquid temperature of from 70°C to 130°C, and a persulfuric acid concentration of from 0.50 mM as O to 25 mM as O, with the unit "mM as O" representing a millimolar concentration obtainable when each of the concentrations is calculated relative to the concentration of oxygen atoms generated from the respective substances, and,
wherein the sulfuric acid solution containing persulfuric acid is either one or both of an electrolyzed sulfuric acid solution obtained by electrolyzing a sulfuric acid solution and a solution obtained by incorporating ozone into a sulfuric acid solution.

2. The metal gate semiconductor cleaning method according to claim 1, wherein the contact time between the sulfuric acid solution containing persulfuric acid and the semiconductor in the persulfuric acid cleaning step is 5 minutes or less.

3. The metal gate semiconductor cleaning method according to claim 1 or 2, the method further comprising, after the persulfuric acid cleaning step, an SC-1 cleaning step of bringing the semiconductor that has been cleaned in the persulfuric acid cleaning step into contact with a solution containing ammonia and hydrogen peroxide.

4. The metal gate semiconductor cleaning method according to any one of claims 1 to 3, wherein the material of the metal gate is one or more selected from TiN, NiSi and TiAlN.

5. The metal gate semiconductor cleaning method according to any one of claims 1 to 4, wherein the gate width of the metal gate is 45 nm or less.

6. The metal gate semiconductor cleaning method according to any one of claims 1 to 5, wherein the persulfuric acid cleaning step is carried out by single wafer cleaning.

## Patentansprüche

1. Metall-Gate-Halbleiterreinigungsverfahren zum Reinigen eines Halbleiters mit einem Metall-Gate, wobei das Verfahren Folgendes beinhaltet:
einen Veraschungsschritt zum Veraschen eines Fotoresists auf dem Halbleiter; und
nach dem Veraschungsschritt einen Perschwefelsäure-Reinigungsschritt des Inkontaktbringens des der Veraschungsverarbeitung unterzogenen Halbleiters mit einer Perschwefelsäure enthaltenden Schwefelsäurelösung, um dadurch den Fotoresist auf dem Halbleiter von dem Halbleiter abzulösen,
wobei die Schwefelsäurelösung, die Perschwefelsäure enthält, die in dem Perschwefelsäure-Reinigungsschritt benutzt wird, eine Wasserstoffperoxidkonzentration von 16 mM als O oder weniger, eine Schwefelsäurekonzentration von 90 Masse-% bis 96 Masse-%, eine Flüssigkeitstemperatur von 70°C bis 130°C und eine Perschwefelsäurekonzentration von 0,50 mM als O bis 25 mM als O hat, wobei die Einheit "mM als O" eine millimolare Konzentration repräsentiert, die erhalten werden kann, wenn jede der Konzentrationen relativ zu der Konzentration von Sauerstoffatomen berechnet wird, die von den jeweiligen Substanzen erzeugt werden, und
wobei die Perschwefelsäure enthaltende Schwefelsäurelösung entweder eine oder beide aus einer elektrolysierten Schwefelsäurelösung, die durch Elektrolysieren einer Schwefelsäurelösung erhalten wird, und einer Lösung ist, die durch Integrieren von Ozon in eine Schwefelsäurelösung erhalten wird.

2. Metall-Gate-Halbleiterreinigungsverfahren nach Anspruch 1, wobei die Kontaktzeit zwischen der Perschwefelsäure enthaltenden Schwefelsäurelösung und dem Halbleiter in dem Perschwefelsäure-Reinigungsschritt 5 Minuten oder weniger beträgt.

3. Metall-Gate-Halbleiterreinigungsverfahren nach Anspruch 1 oder 2, wobei das Verfahren ferner, nach dem Perschwefelsäure-Reinigungsschritt, einen SC-1 Reinigungsschritt des Inkontaktbringens des Halbleiters, der in dem Perschwefelsäure-Reinigungsschritt gereinigt wurde, mit einer Lösung beinhaltet, die Ammoniak und Wasserstoffperoxid enthält.

4. Metall-Gate-Halbleiterreinigungsverfahren nach einem der Ansprüche 1 bis 3, wobei das Material des Metall-Gate eines oder mehrere ausgewählt aus TiN, NiSi und TiAlN ist.

5. Metall-Gate-Halbleiterreinigungsverfahren nach einem der Ansprüche 1 bis 4, wobei die Gate-Breite des Metall-Gate 45 nm oder weniger beträgt.

6. Metall-Gate-Halbleiterreinigungsverfahren nach einem der Ansprüche 1 bis 5, wobei der Perschwefelsäure-Reinigungsschritt durch einzelne Wafer-Reinigung durchgeführt wird.

## Revendications

1. Procédé de nettoyage de semi-conducteur à grille métallique destiné à nettoyer un semi-conducteur ayant une grille métallique, le procédé comportant :
une étape d'incinération consistant à incinérer une résine photosensible sur le semi-conducteur ; et
après l'étape d'incinération, une étape de nettoyage à l'acide persulfurique consistant à mettre le semi-conducteur qui a été soumis à l'étape d'incinération en contact avec une solution d'acide sulfurique contenant de l'acide persulfurique, et de ce fait décaper la résine photosensible se trouvant sur le semi-conducteur pour la retirer du semi-conducteur,
dans lequel la solution d'acide sulfurique contenant de l'acide persulfurique servant au cours de l'étape de nettoyage à l'acide persulfurique présente une concentration en peroxyde d'hydrogène de 16 mM en O ou moins, une concentration en acide sulfurique allant de 90 % en masse à 96 % en masse, une température de liquide allant de 70°C à 130°C, et une concentration en acide persulfurique allant de 0,50 mM en O à 25 mM en O, l'unité « mM en O » représentant une concentration en millimolaires pouvant être obtenue quand chacune des concentrations est calculée par rapport à la concentration en atomes d'oxygène générés en provenance des substances respectives, et,
dans lequel la solution d'acide sulfurique contenant de l'acide persulfurique est soit l'une soit les deux parmi une solution d'acide sulfurique électrolysée obtenue par l'électrolyse d'une solution d'acide sulfurique et une solution obtenue par l'incorporation d'ozone dans une solution d'acide sulfurique.

2. Procédé de nettoyage de semi-conducteur à grille métallique selon la revendication 1, dans lequel le temps de contact entre la solution d'acide sulfurique contenant de l'acide persulfurique et le semi-conducteur au cours de l'étape de nettoyage à l'acide persulfurique est de 5 minutes ou moins.

3. Procédé de nettoyage de semi-conducteur à grille métallique selon la revendication 1 ou la revendication 2, le procédé comportant par ailleurs, après l'étape de nettoyage à l'acide persulfurique, une étape de nettoyage SC-1 consistant à mettre le semi-conducteur qui a été nettoyé au cours de l'étape de nettoyage à l'acide persulfurique en contact avec une solution contenant de l'ammoniac et du peroxyde d'hydrogène.

4. Procédé de nettoyage de semi-conducteur à grille métallique selon l'une quelconque des revendications 1 à 3, dans lequel le matériau de la grille métallique est l'un ou plusieurs sélectionnés parmi du TiN, du NiSi et du TiAlN.

5. Procédé de nettoyage de semi-conducteur à grille métallique selon l'une quelconque des revendications 1 à 4, dans lequel la largeur de grille de la grille métallique est de 45 nm ou moins.

6. Procédé de nettoyage de semi-conducteur à grille métallique selon l'une quelconque des revendications 1 à 5, dans lequel l'étape de nettoyage à l'acide persulfurique est effectuée par le nettoyage d'une seule tranche.
